# EUROPEAN PATENT APPLICATION

(11) **EP 1 903 340 A1**
(43) Date of publication of application: **26.03.2008**
(21) Application number: 07110814.6
(22) Date of filing: 21.06.2007
(51) Int. Cl.: G01R 1/073, G01R 3/00

(54) **Probe substrate for test and manufacturing method thereof**

(30) Priority: 21.09.2006 KR 20060091621
(71) Applicant: Apex International, Inc., Suwon City, Kyungki-do (KR)
(72) Inventor: Rhyu, Dal-Lae 412-1906 Poonglim Apt.,, SUWON-SI, GYEONGGI-DO (KR)
(74) Representative: Modiano, Micaela Nadia

(57) **Abstract**

A probe substrate includes a probe having a plurality of beams and a contactor formed at one end of the beam, and a support substrate for supporting the probe and having a bending space in which the probe moves upwards and downwards. The beam and the contactor are made of the same metal, and the sidewall of the contactor has a staircase configuration. Therefore, the probe substrate and the manufacturing method thereof repeats the lithographic process and the plating process to form the probe having the beam and the contactor combined, thereby increasing the bending degree and structural stability of the probe.

## Description

### BACKGROUND OF THE INVENTION

### (a) Field of the Invention

The present invention relates to a probe substrate and a manufacturing method thereof, and more particularly relates to a probe substrate including a probe for electrically testing a semiconductor integrated circuit (IC) device formed on a semiconductor wafer, and a manufacturing method thereof,

### (b) Description of the Related Art

In general, a semiconductor integrated circuit (IC) device is made using a predetermined semiconductor manufacturing process. An electrical test is applied during or after the manufacturing process to determine what products are non-functional. In the electrical test, a test equipment for receiving various electrical signals from the outside, detecting response signals of the semiconductor integrated circuit, and analyzing the response signals is used, and a probe for electrically connecting the test equipment and the semiconductor integrated circuit is needed. A similar test process is performed during or after the manufacturing process of flat panel displays such as the liquid crystal displays (LCDs), and a probe for electrically connecting the test equipment and elements is also needed.

The beam and the contactor of the probe are made by respective silicon wafers, and the probe is made by precisely arranging the two wafers and adhering the beam and the contactor using a heat pressing method applying metal such as gold (Au) between the wafers.

However, this process doubles the silicon wafer process for forming the beam and the contactor, and increases the process cost because of the gold used in the heat pressing process. Also, mass production is difficult since the yield of the heat pressing process with fine arrangement is poor, and the bending degree and structural stability of the probe is deteriorated since the interface adhesion between the beam and the contactor is poor.

### SUMMARY OF THE INVENTION

Accordingly, the present invention has been made to solve the above-mentioned problems occurring in the prior art, and an object of the present invention is to provide a probe substrate with improved bending degree and structural stability, and a manufacturing method thereof. In one embodiment of the present invention, a probe substrate includes a probe having a plurality of beams and a contactor formed at one end of the beam, and a support substrate supporting the probe and having a bending space in which the probe can be bent upwards and downwards. The contactor includes a first tip formed on the beam using a first electroplating process and a second tip formed on the first tip using a second electroplating process, and an interface is provided at a space between the first tip and the second tip since the first tip and the second tip are formed using the different electroplating processes.

A trench oxide layer is formed on an upper surface of the support substrate, and the beam and a predetermined part of the support substrate are spaced with a predetermined gap therebetween for provding the bending space. The trench oxide layer is located adjacent to the bending space, and a sidewall of the bending space slopes. A through hole is formed in the support substrate, and the through hole is filled by a connection member The trench oxide layer is a thermal oxide layer formed at a plurality of microtrenches on the surface of the support substrate. The beam is made of one metal of nickel (Ni), copper (Cu), platinum (Pt), palladium (Pd), rhodium (Rh), and gold (Au), or an alloy made of one of the metals as a major element and other metals as minor elements.

The contactor includes a first tip contacting the beam, a second tip formed on the first tip and having a diameter that is less than that of the first tip, and a third tip formed on the second tip and having a diameter that is less than that of the second tip. An insulation layer is formed on the surface of the support substrate other than at the surface of a bending space of the support substrate. The insulation layer is formed between the support substrate and the beam, and the connection member contacts the beam.

In another embodiment of the present invention, a method for manufacturing a probe substrate includes: forming a plurality of through holes in a support substrate; forming an insulation layer on the surface of the support substrate; forming a connection member in the respective through hole; forming a plurality of beams on the insulation layer formed on the support substrate; forming a contactor at one end of the beam by using the same metal as that of the beam; and etching a predetermined part of the support substrate provided at the lower part of the beam to form a bending space, wherein the forming of the contactor includes forming a contactor forming photoresist layer pattern for exposing one end of the beam on the beam, and forming a metal layer on the exposed part of the beam by using an electroplating method. The method further includes, before forming a plurality of through holes on the support substrate, forming a plurality of microtrenches on the support substrate and filling the microtrenches with a thermal oxide layer to form a trench oxide layer. The trench oxide layer is located adjacent to an edge between the bending space and the beam. The forming of a plurality of beams includes: patterning the insulation layer formed on the support substrate and exposing part of the support substrate corresponding to the bending space; forming a sacrificial metal layer on the exposed support substrate; forming a seed layer on the sacrificial metal layer and the insulation layer; forming a first photoresist layer pattern for generating the beam on the seed layer and exposing part of the seed layer; and filling the part exposed by the first photoresist layer pattern with metal by using an electroplating method, thereby forming the plurality of beams. The photoresist layer pattern includes a plurality of long bar patterns in the horizontal direction. One end of the respective long bar pattern of the photoresist layer pattern corresponds to the connection member. The beam is made of one of nickel (Ni), copper (Cu), platinum (Pt), palladium (Pd), rhodium (Rh), and gold (Au), or an alloy made of one of the metals as a major element and other metals as minor elements. The etching of part of the support substrate to form the bending space includes etching the sacrificial metal layer to form the space between the beam and the support substrate, and etching the support substrate exposed through the space and forming the bending space. The forming of the contactor includes forming a circular-shaped first tip at one end of the beam by using the electroplating method, forming a second tip having a diameter that is less than that of the first tip on the first tip, and forming a third tip having a diameter that is less than that of the second tip on the second tip. The forming of the first tip includes forming a second photoresist layer pattern on a first photoresist layer pattern and the beam to expose an end part of the beam, and filling the part exposed by the second photoresist layer pattern with metal by using the electroplating method to form the first tip. The first photoresist layer pattern is circular-shaped or quadrilateral-shaped. The forming of the second tip includes forming the second photoresist layer pattern on the first photoresist layer pattern and the first tip to expose a center of the first tip, and filling the part exposed by the second photoresist layer pattern with the metal by using an electroplating method and forming the second tip. The forming of the third tip includes forming a third photoresist layer pattern on the second photoresist layer pattern and the second tip to expose the center of the second tip, and filling the part exposed by the third photoresist layer pattern with metal by using the electroplating method to form the third tip. The method further includes repeating the process for forming the first to third tips to form a tip having a diameter that is less than that of the third tip on the third tip.

### BRIEF DESCRIPTION OF THE DRAWINGS

The above and other objects, features, and advantages of the present invention will be more apparent from the following detailed description taken in conjunction with the accompanying drawings, in which:
FIG. A is a top plan view of a probe substrate according to a preferred embodiment of the present invention;
FIG. 1B is a cross-sectional view taken along the line Ib-Ib of FIG. 1A;
FIG. 2A is a top plan view of a probe substrate in a manufacturing method according to a preferred embodiment of the present invention;
FIG. 2B is a cross-sectional view taken along the line llb-llb of FIG. 2A;
FIG. 3 is a cross-sectional view showing a next step of FIG. 2B;
FIG. 4A is a top plan view showing a next step of FIG. 3;
FIG. 4B is a cross-sectional view taken along the line IVb-IVb of FIG. 4A;
FIG. 5 is a cross-sectional view showing a next step of FIG. 4B;
FIG. 6A is a top plan view showing a next step of FIG. 5;
FIG. 6B is a cross-sectional view taken along the line Vlb-Vlb of FIG. 6A;
FIGs. 7 to 11 sequential illustrate cross-sectional views showing next steps of FIG. 6B;
FIG. 12A is a top plan view showing a next step of FIG. 11;
FIG. 12B is a cross-sectional view taken along the line Xllb-Xllb of FIG. 12A;
FIG, 13A is a top plan view showing a next step of FIG. 12A;
FIG. 13B is a cross-sectional view taken along the line Xlllb-Xllfb of FIG. 13A; and
FIGs. 14 to 21 sequentially illustrate cross-sectional views showing next steps of FIG. 13B.

### DETAILED DESCRIPTION OF THE EMBODIMENTS

Hereinafter, a preferred embodiment of the present invention will be described with reference to the accompanying drawings. As those skilled in the art would realize, the described embodiments may be modified in various different ways, all without departing from the spirit or scope of the present invention. In the following description of the present invention, a detailed description of known functions and configurations incorporated herein will be omitted when it may make the subject matter of the present invention unclear.

A probe substrate and a manufacturing method thereof according to a preferred embodiment of the present invention will now be described with reference to drawings.

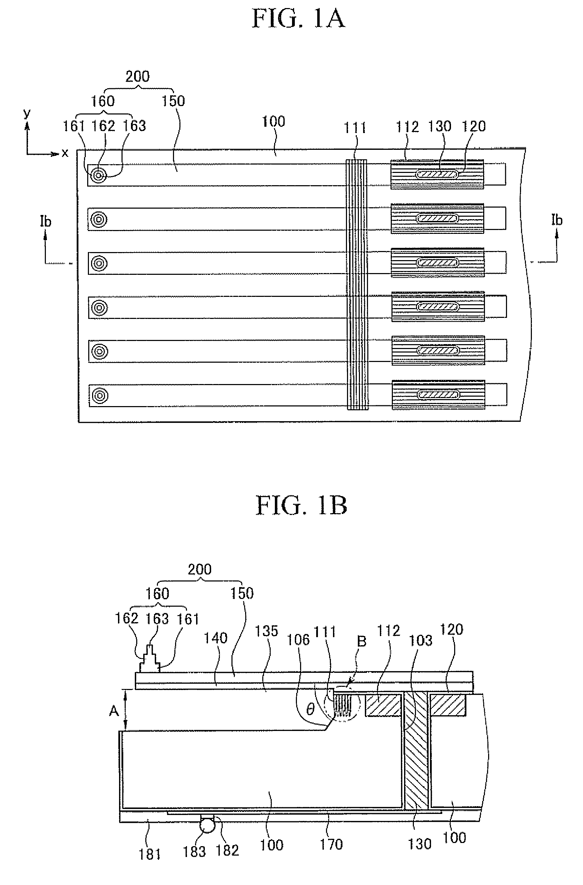

FIG. 1A is a top plan view of a probe substrate according to a preferred embodiment of the present invention, and FIG. 1 B is a cross-sectional view taken along the line lb-lb of FIG. 1A,

As shown in FiGs. 1A and 1B, the probe substrate includes a support substrate 100, and a probe 200 provided on the support substrate 100.

The support substrate 100 is preferably made of a single crystal silicon wafer, and an insulation layer 120 is formed on the surface of the support substrate 100.

A trench oxide layer 111 is formed around an upper surface of the support substrate 100, a through hole 103 is formed with a predetermined distance from the trench oxide layer 111, and a connection member 130 fills the through hole 103. The trench oxide layer 111 is generated by using a thermal oxide layer, thereby providing excellent electrical insulation and hardness.

The probe 200 includes a beam 150 electrically connected to the connection member 130 of the support substrate 100, and a contactor 160 formed at the one end of the beam 150 and attached to the beam 150 in a vertical direction. The beam 150 is made of one metal of nickel (Ni), copper (Cu), platinum (Pt), palladium (Pd), rhodium (Rh), and gold (Au), or an alloy made of one of the metals as a major element and other metals as minor elements. The contactor 160 has a staircase-type sidewall and an upper part thereof has a diameter that is less than that of a lower part.

The contactor 160 includes a first tip 161 contacted to the beam 150, a second tip 162 that is formed on the first tip 161 with a diameter less than that of the first tip 161, and a third tip 163 formed on the second tip 162 with a diameter less than that of the second tip 162. The contactor 160 electrically connects the probe substrate of a test equipment with a semiconductor integrated circuit in an electrical test.

In the preferred embodiment of the present invention, the contactor 160 having three tips 161, 162, and 163 is described. The number of tips of the contactor 160 is not limited to three.

A seed layer 140 is attached below the beam 150, and the seed layer 140 is made of one of nickel (Ni), copper (Cu), platinum (Pt), palladium (Pd), rhodium (Rh), and gold (Au), or an alloy made of one of the metals as a major element and other metals as minor elements.

A predetermined part of the support substrate 100 provided on a lower part of the beam 150 is removed to form a bending space (A) in which the beam 150 is bent upwards and downwards. The beam 150 and the predetermined part of the support substrate 100 are spaced with a predetermined gap therebetween for providing the bending space (A). The beam 150 moves elastically and minutely upwards and downwards in the bending space (A).

Preferably, a sidewall 106 of the bending space (A) has a slope, and an upper part of the sidewall 106 contacts to the beam 150. More particularly, the sidewall 106 of the bending space (A) and the beam 150 has a predetermined angle (θ) therebetween.

The trench oxide layer 111 is provided at the boundary between the beam 150 and the sidewall 106 of the bending space (A), i.e., the boundary (B) between the beam 150 and the support substrate 100, More particularly, the trench oxide layer 111 is formed around the sidewall 106 of the bending space (A). Therefore, the trench oxide layer 111 prevents the boundary (B) from being damaged because of stress applied to the boundary (B) between the beam 150 and the support substrate 100 by the repeated bending operation of the beam 150, and prevents electricity leakage by maintaining electrical insulation between the beam 150 and the support substrate 100.

As shown in FIG. 1A, the trench oxide layer 111 is provided in the Y direction being perpendicular to the longitudinal direction (X direction) of the beam 150.

An auxiliary trench oxide layer 112 is formed around the connection member 130, and the auxiliary trench oxide layer 112 is provided in the X direction being perpendicular to the Y direction of the trench oxide layer 111. The auxiliary trench oxide layer 112 is provided in the X direction so as to prevent the connection member 130 from being damaged when the support substrate 100 is bent in the Y direction by the trench oxide layer 111.

The insulation layer 120 is not formed on the surface of the bending space (A), an insulation layer 120 is formed at a space between the support substrate 100 and the seed layer 140, and the connection member 130 and the beam 150 contact each other through the seed layer 140 as a medium.

Another end of the beam 150 is connected to a circuit 170 formed below the support substrate 100 through the connection member 130. A solder resist 181 and a solder pad 182 are formed below the circuit 170. A solder ball 183 is attached to the solder pad 182.

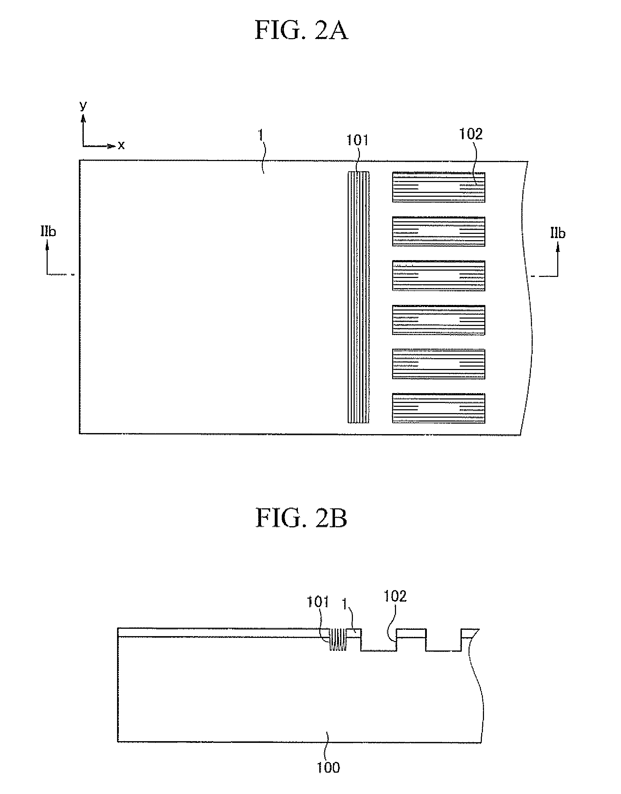

FIGs. 2 to 21 sequentially illustrate a probe substrate manufacturing method according to a a preferred embodiment of the present invention.

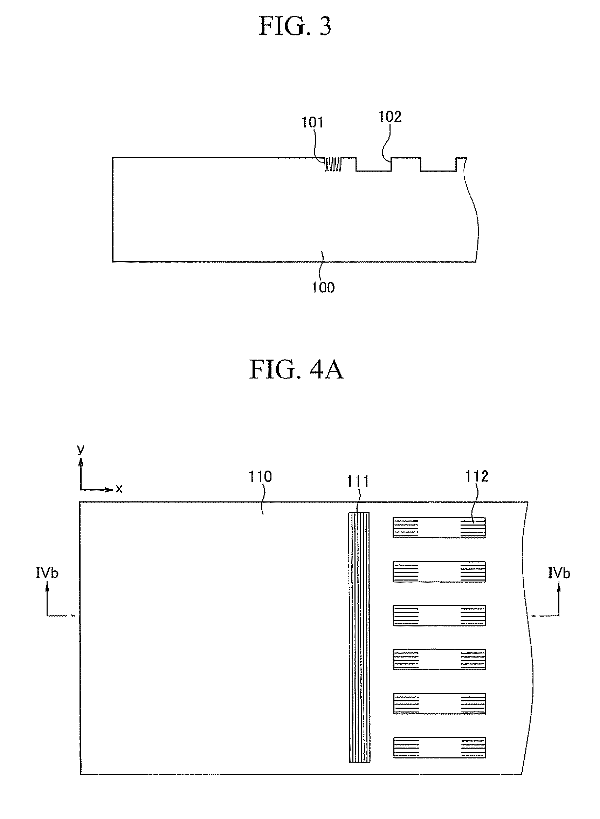

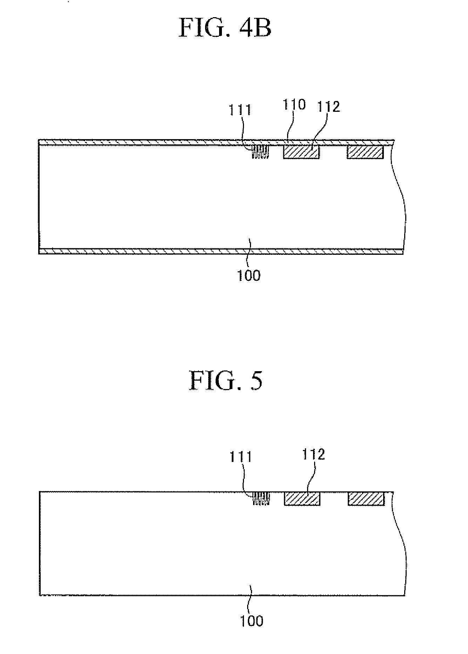

FIG. 2A is a top plan view of a probe substrate manufacturing method according to a preferred embodiment of the present invention, and FIG. 2B is a cross-sectional view taken along the line llb-llb of FIG. 2A. FIG. 3 is a cross-sectional view showing a next step of FIG. 2B. FIG. 4A is a top plan view showing a next step of FIG. 3, and FIG. 4B is a cross-sectional view taken along the line lVb-lVb of FIG. 4A. FIG. 5 is a cross-sectional view showing a next step of FIG. 4B.

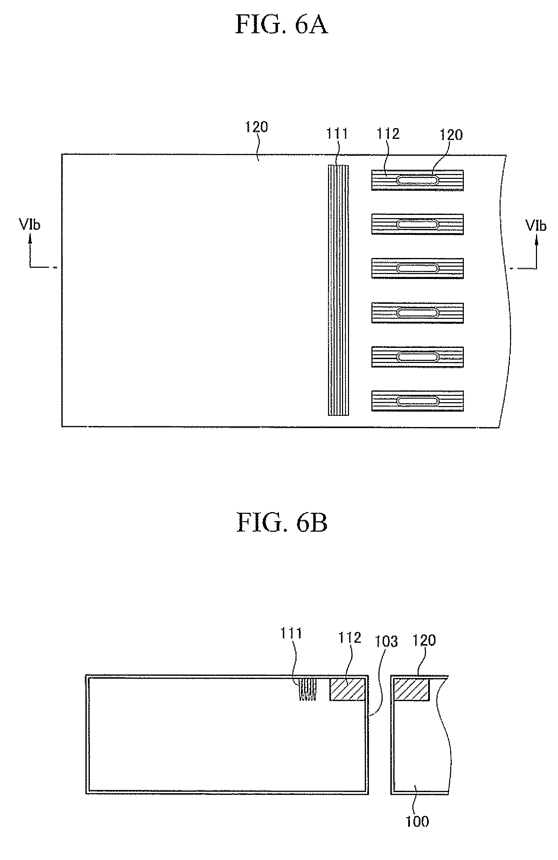

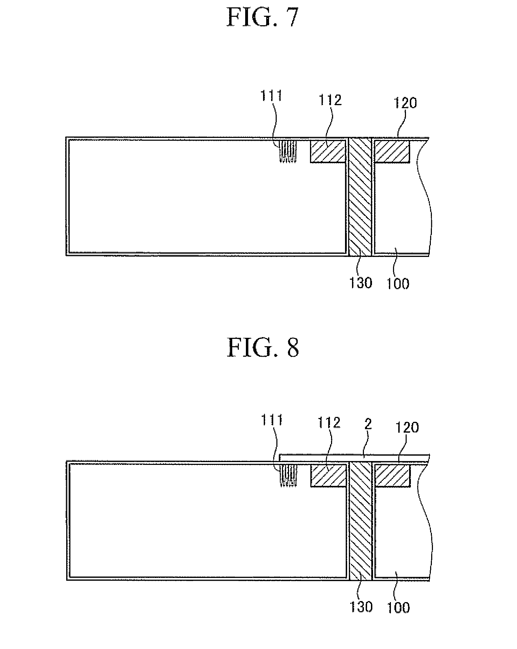

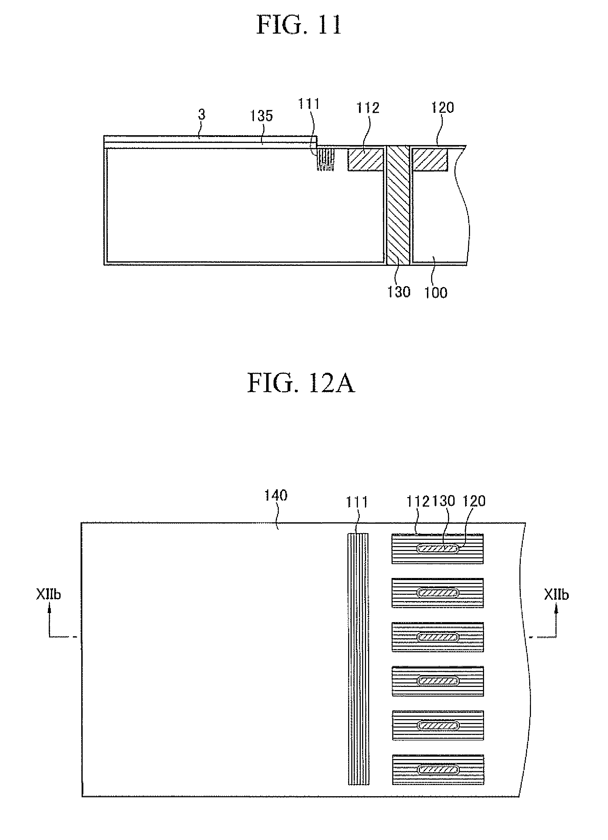

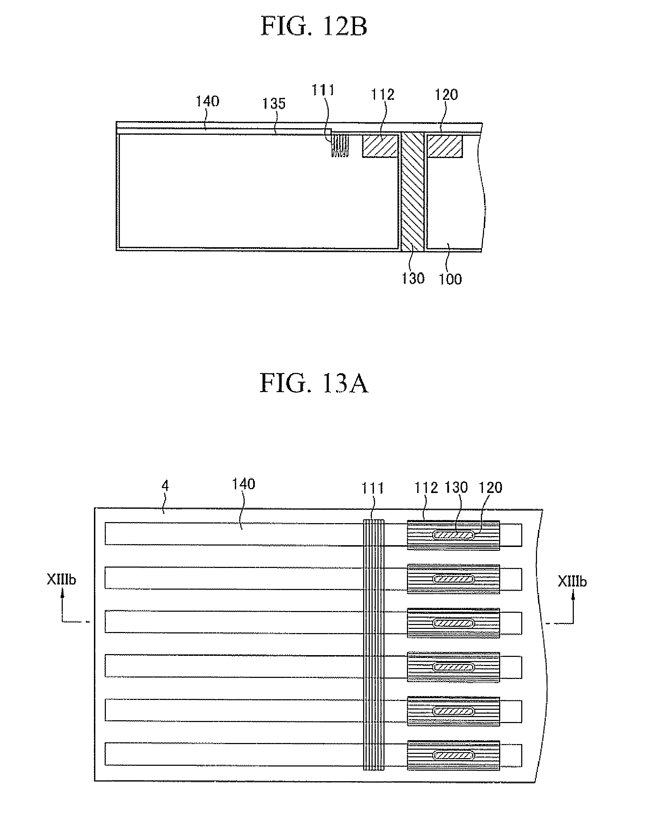

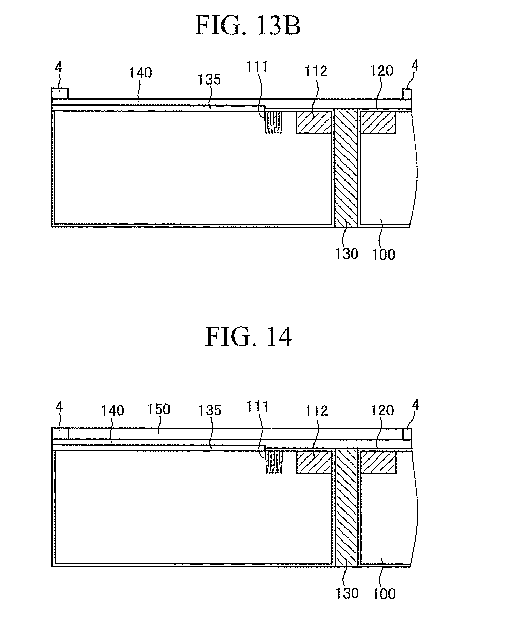

FIGs. 3 to 5 sequentially illustrate a top plan view showing a next step of FIG. 2B, FIG. 6A is a top plan view showing a next step of FIG. 5, and FIG. 6B is a cross-sectional view taken along the line Vlb-Vlb of FIG. 6A. FIGs. 7 to 11 sequentially illustrate cross-sectional views showing next steps of FIG. 6B. FIG. 12A is a top plan view showing a next step of FIG. 11, and FIG. 12B is a cross-sectional view taken along the line Xllb-Xllb of FIG. 12A. FIG. 13A is a top plan view showing a next step of FIG. 12A, and FIG. 13B is a cross-sectional view taken along the line Xlllb-Xlllb of FIG. 13A. FIGS. 14 to 21 sequentially illustrate cross-sectional views showing a next step of FIG. 13B.

As shown in FiGs, 2A and 2B, a photoresist layer is formed on the support substrate 100, and the photoresist layer is exposed and developed to form a first photoresist layer pattern 1. The photoresist layer may be a positive photoresist layer (when a light is illuminated, the illuminated part of the photoresist layer is developed and removed) or a negative photoresist layer (when a light is illuminated, the illuminated part is cured and remains after developing). The first photoresist layer pattern 1 is set as an etching mask, and a dry etching method such as reactive ion etching (RIE) using ozone plasma is used to form a plurality of microtrenches 101 and auxiliary microtrenches 102 on the surface of the support substrate 100. The depth of the microtrenches 101 is preferably ranged from 30 to 50. When the depth of the microtrench 101 is less than 30, hardness-improving effect is not achieved at the boundary between the beam and the support substrate. When the depth of the microtrench 101 is greater than 50, shape of the support substrate 100 is deformed by volume expansion during the subsequent oxide layer forming process. Thus, the planarity of the surface of the support substrate100 may deteriorate and the support substrate may be damaged. As shown in FIG. 2A, the microtrench 101 is provided in the Y direction, and the auxiliary microtrench 102 is provided in the X direction.

As shown in FIG. 3, the first photoresist layer pattern 1 is removed, and the support substrate 100 is cleaned so as to remove a polymer that is formed by an etching gas (C₄F₈) generated in the dry etching process and fine particles that may be generated under other conditions. Plasma and cleaning chemicals are used during the process.

As shown in FIGs. 4A and 4B, thermal oxide layers (SiO₂) 110, 111, and 112 are formed on the support substrate 100, in the microtrenches 101, and in the auxiliary microtrenches 102, respectively. In order to form the thermal oxide layers 110, 111, and 112, the silicon (Si) of the support substrate 100 is oxidized to be expanded to about 1.4 times under the condition of a high temperature of greater than 1100°C, gas of PN2 with high purity, and moisture. Particularly, the thermal oxide layer 111 formed on the inner surface of the microtrenches 101 fills the microtrenches 101. The trench oxide layer 111 having filled the microtrenches 101 has excellent electrical insulation and hardness. Therefore, the boundary (B) between the beam 150 and the support substrate 100 is prevented from being damaged by the stress applied to the boundary (B) according to the bending operation of the beam 150 by locating the trench oxide layer 111 at the boundary (B), and electrical leakage is prevented by maintaining the electrical insulation between the beam 150 and the support substrate 100. The trench oxide layer 111 is formed to be provided in the Y direction.

The thermal oxide layer 112 formed on the inner surface of the auxiliary microtrenches 102 fills the auxiliary microtrenches 102. The auxiliary trench oxide layer 112 is formed in the X direction with respect to the Y direction in which the trench oxide layer 111 is provided so as to prevent the support substrate 100 from being bent by the trench oxide layer 111.

As shown in FIG. 5, the surface of the support substrate 100 is polished to remove the thermal oxide layer 110 other than the trench oxide layer 111 and the auxiliary trench oxide layer 112 and planarize the surface of the support substrate 100. The upper parts of the trench oxide layer 111 and the auxiliary trench oxide layer 112 are expanded and protruded during the thermal oxide layer forming process, so the upper parts thereof are polished to be planarized.

As shown in FIGS. 6A and 6B, an etch mask is formed on the support substrate 100, and the support substrate 100 is etched to form a plurality of through holes 103 at predetermined locations of the support substrate 100. The respective through hole 103 is formed with a predetermined gap from the trench oxide layer 111, and is surrounded by the auxiliary trench oxide layer 112. The auxiliary trench oxide layer 112 prevents the through hole 103 from being deformed by the trench oxide layer 111. Preferably, a metal layer of Al, Cr, or a silicon compound of a silicon nitride film or a silicon oxide film is used as the etch mask, or only the photoresist layer is used.

A thermal oxidation process or a chemical vapor deposition (CVD) process is performed to form an insulation layer 120 such as a silicon oxide layer or a silicon nitride layer on the entire surface of the support substrate 100. In this instance, the insulation layer 120 is formed on the inner surface of the through hole 103.

As shown in FIG. 7, the through hole 103 is filled with a conductive material for connecting electrical signals to form a connection member 130.

As shown in FIG. 8, a photoresist layer is formed on the support substrate 100 on which the insulation layer 120 is formed, and the photoresist layer is exposed and developed to form a second photoresist layer pattern 2. The second photoresist layer pattern 2 covers the trench oxide layer 111, the auxiliary trench oxide layer 112, and the connection member 130, and does not cover the part corresponding to the bending space (A). Therefore, the insulation layer 120 is exposed at the part that is not covered by the second photoresist layer pattern 2.

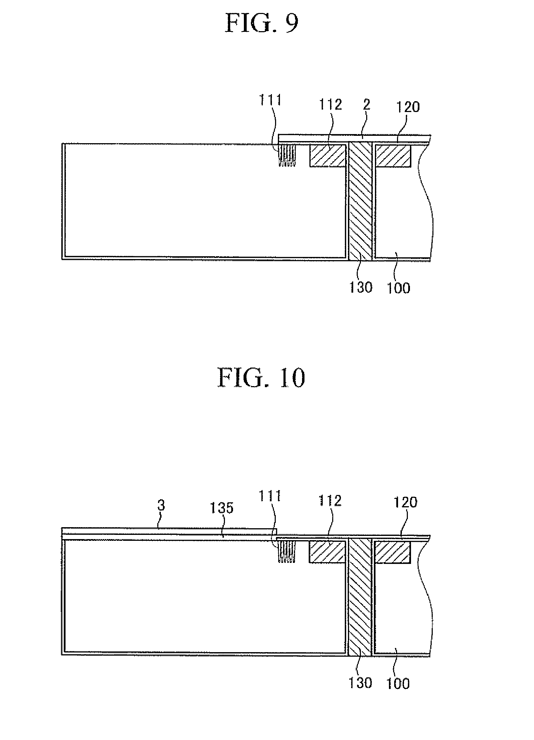

As shown in FIG. 9, with using the second photoresist layer pattern 2 as an etch mask, the exposed insulation layer 120 is etched to expose part of the support substrate 100.

As shown in FIG. 10, the second photoresist layer pattern 2 is removed, and a sacrificial metal layer 135 of aluminum is formed on the exposed support substrate 100 and the insulation layer 120. A third photoresist layer pattern 3 is formed on the sacrificial metal layer 135. The third photoresist layer pattern 3 is formed at a location other than the location where the second photoresist layer pattern 2 is formed. More particularly, the third photoresist layer pattern 3 does not cover the trench oxide layer 111, the auxiliary trench oxide layer 112, and the connection member 130, and the sacrificial metal layer 135 is exposed on the part that is not covered by the third photoresist layer pattern 3.

As shown in FIG. 11, the third photoresist layer pattern 3 is set as an etch mask to etch the exposed sacrificial metal layer 135. Therefore, the sacrificial metal layer 135 does not cover the trench oxide layer 111, the auxiliary trench oxide layer 112, and the connection member 130.

As shown in FIGs. 12A and 12B, the third photoresist layer pattern 3 is removed, and a seed layer 140 is formed on the exposed sacrificial metal layer 135 and the insulation layer 120. The seed layer 140 is preferably formed with bi-layers of a adhesion layer and a conductive layer. The upper layer is preferably formed as a conductive layer by using a metal of one of nickel (Ni), copper (Cu), platinum (Pt), palladium (Pd), rhodium (Rh), and gold (Au), or an alloy made of one of the metals as a major element and other metals as minor elements. And, the lower layer is preferably formed as a adhesion layer for controlling the conductive layer to be properly deposited on the support substrate 100 by using titanium (Ti). The thickness of the seed layer is preferably ranged from 1000Å to 4000Å.

As shown in FiGs. 13A and 13B, a photoresist layer is formed on the seed layer 140, and the photoresist layer is exposed and developed to form a fourth photoresist layer pattern 4. The thickness of the fourth photoresist layer pattern 4 is preferably ranged from 70 to 100. As shown in FIG. 13B, the fourth photoresist layer pattern 4 includes a plurality of long bar patterns in the horizontal direction, and one end of the long bar of the fourth photoresist layer pattern 4 corresponds to the connection member 130. The seed layer 140 is exposed by the fourth photoresist layer pattern 4.

As shown in FIG. 14, the seed layer 140 is plated with the metal (metal of one of nickel (Ni), copper (Cu), platinum (Pt), palladium (Pd), rhodium (Rh), and gold (Au) or an alloy made of one of the metals as a major element and other metals as minor elements) by using the electroplating method to fill the part exposed by the fourth photoresist layer pattern 4 and form a plurality of beams 150. It is controlled to generate no voids when the support substrate 100 is immersed into the electroplating solution in which the seed layer 140 is formed using the electroplating method. Preferably, since the copper (Cu) and gold (Au) have good softness and the nickel (Ni), platinum (Pt), palladium (Pd), and rhodium (Rh) have good mechanical characteristics, the metal is selectively applied depending on a target material to be contacted. Also, it is possible to apply the above-described alloy. Accordingly, the beam is made of metal, thereby improving the strength of the beam.

The irregular upper part of the beam 150 generated by the plating process is planarized by polishing the upper part thereof by using a chemical mechanic polishing process. Therefore, the plainness of the beam 150 with a uniform thickness is preferably ranged from 1 to 2 is formed. Since the particles of the beam 150 generated in the polishing process remain on the support substrate 100, the particles are removed by performing a cleaning process by applying sonic vibration to deionized water and immersing it therein in a subsequent process.

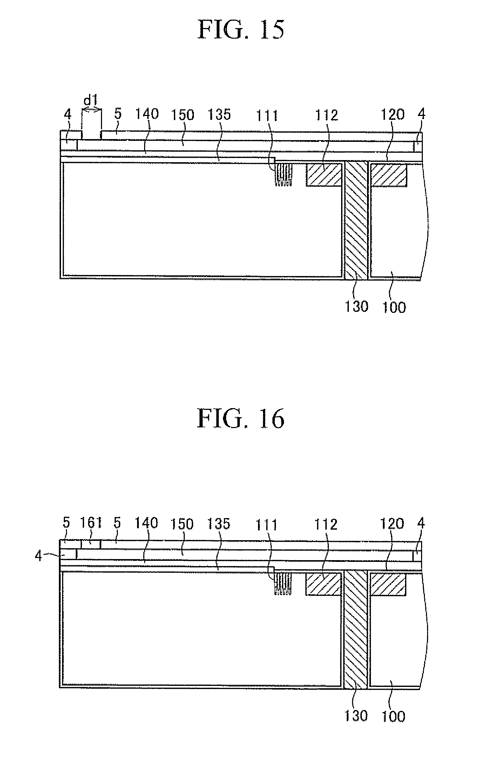

As shown in FIG. 15, a fifth photoresist layer pattern 5 is formed on the fourth photoresist layer pattern 4 and the beam 150. The fifth photoresist layer pattern 5 is a circular-shaped or quadrilateral-shaped pattern having a diameter (d1), preferably from 50 to 70, and exposes one end of the beam 150.

As shown in FIG. 16, the beam 150 is plated with the same metal as the seed layer 140 by using the electroplating method, and hence the part exposed by the fifth photoresist layer pattern 5 is filled to form a first tip 161. The irregular upper part of the first tip 161 is polished to be planarized.

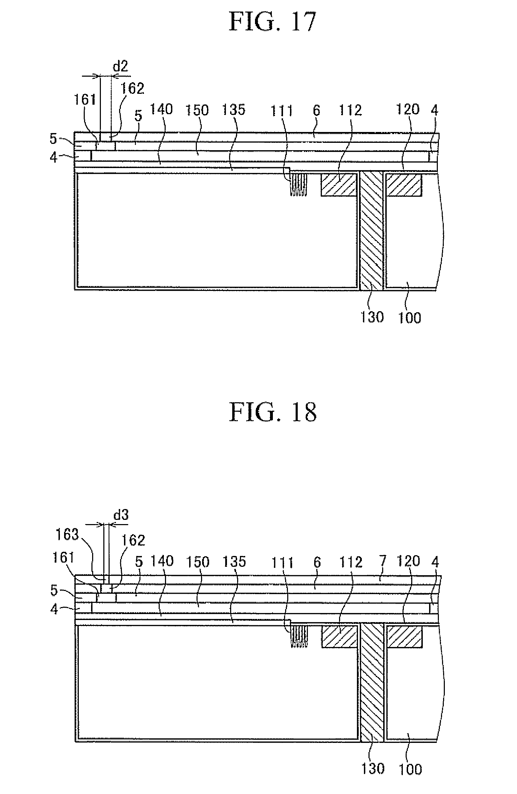

As shown in FIG. 17, a sixth photoresist layer pattern 6 is formed on the first tip 161 and the fifth photoresist layer pattern 5. The sixth photoresist layer pattern 6 is a circular-shaped or quadrilateral-shaped pattern having a diameter (d2) being less than that of the first tip 161, and exposes a center of the first tip 161. The diameter (d2) is preferably ranged from 35 to 60. The part exposed by the sixth photoresist layer pattern 6 is filled by plating the same metal as that of the beam 150 by using the electroplating method, thereby forming the second tip 162 on the first tip 161. The irregular upper part of the second tip 162 is polished to be planarized.

As shown in FIG. 18, a seventh photoresist layer pattern 7 is formed on the second tip 162 and the sixth photoresist layer pattern 6. The seventh photoresist layer pattern 7 is a circular-shaped or quadrilateral-shaped pattern having a diameter (d3) being less than that of the second tip 162, and exposes a center of the second tip 162. The diameter (d3) is preferably ranged from 25 to 40. The same material as that of the beam 15 is plated by using the electroplating method to fill the part exposed by the seventh photoresist layer pattern 7 and form the third tip 163 on the second tip 162. The irregular upper part of the third tip 163 is polished to be planarized.

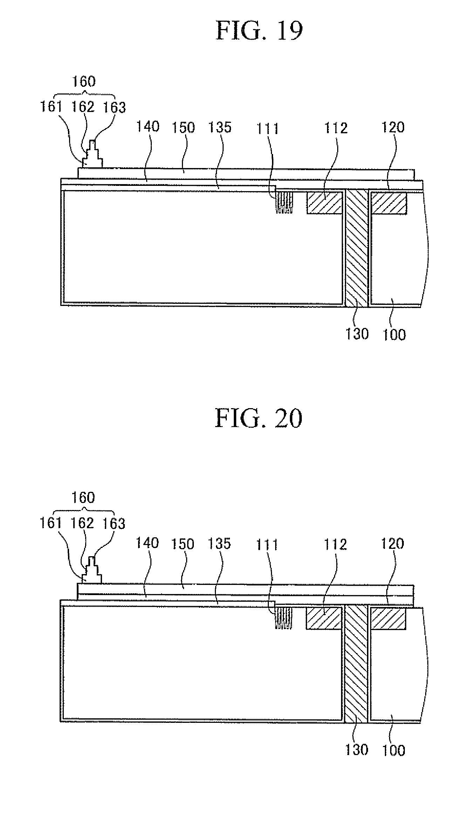

As shown in FIG. 19, the fourth, fifth, sixth and seventh photoresist layer patterns 4, 5, 6, and 7 are removed by using a photoresist stripper thereby exposing the beam 150 and part of the seed layer 140. An end of the contactor 160 is polished to be round-shaped.

The first to third tips 161, 162, and 163 entirely form the contactor 160.

In general, it has been difficult to form the contactor 160 with a height greater than 100 by using the plating process, and it is now possible to form the contactor 160 with a great height using the plating process by forming the contactor to a predetermined height by repeating the plating process.

In the embodiment of the present invention, the three tips 161, 162, and 163 are accumulated to control the height of the contactor 160 for forming the contactor 160, and the height of the contactor 160 can be controlled by accumulating less or further tips.

As shown in FIG. 20, the beam 150 is set as an etching mask to pattern the seed layer 140 and expose a predetermined part of the sacrificial metal layer 135.

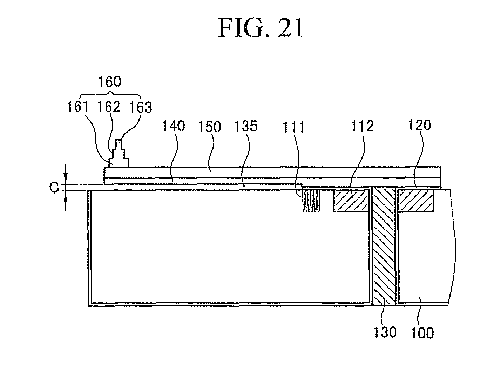

As shown in FIG. 21, the sacrificial metal layer 135 is etched to form a space C between the support substrate 100 and the seed layer 140.

As shown in FIG. 1B, the support substrate 100 exposed through the space C is etched to form a bending space A. In this instance, the support substrate 100 is etched starting from one end of the support substrate 100 to form the bending space A, and the etching is performed up to the part that is adjacent to the trench oxide layer 111. A circuit 170 is formed below the support substrate 100 to connect the connection member 130 and the circuit 170. A solder resist 181 and a solder pad 182 are formed under the circuit 170, and a solder ball 183 is attached to the solder pad 182.

The probe substrate and the manufacturing method thereof according to the embodiment of the present invention repeats the lithographic process and the plating process to form the probe that has the beam and the contactor combined, thereby providing a greater bending degree and structural stability of the probe.

Also, the process is shortened and the production cost is reduced since there is no need for expensive different metals and an arrangement device for the heat press process.

Further, the beam and the contactor are formed of the same metal, and hence the interface junction between the beam and the contactor is excellent.

While this invention has been described in connection with what is presently considered to be practical preferred embodiments, it is to be understood that the invention is not limited to the disclosed embodiments, but, on the contrary, is intended to cover various modifications and equivalent arrangements included within the spirit and scope of the appended claims.

## Claims

1. A probe substrate comprising:
a probe having a plurality of beams and a contactor formed at one end of the beam; and
a support substrate supporting the probe and having a bending space,
wherein the probe bents upwards and downwards in the bending space,
wherein the contactor includes a first tip formed on the beam using a first electroplating process and a second tip formed on the first tip using a second electroplating process, and an interface is provided at a space between the first tip and the second tip.

2. The probe substrate of claim 1, further comprising:
a trench oxide layer formed on an upper surface of the support substrate.

3. The probe substrate of claim 2, wherein
the trench oxide layer is located adjacent to the bending space.

4. The probe substrate of claim 1, wherein
the beam and a predetermined part of the support substrate are spaced with a predetermined gap therebetween for providing the bending space.

5. The probe substrate of claim 1, wherein
a sidewall of the bending space slopes.

6. The probe substrate of claim 1, further comprising:
a through hole formed in the support substrate; and a connection member filling the through hole.

7. The probe substrate of claim 2, wherein
the trench oxide layer is a thermal oxide layer formed at a plurality of microtrenches on the support substrate surface.

8. The probe substrate of claim 1, wherein
the beam is made of one metal of nickel (Ni), copper (Cu), platinum (Pt), palladium (Pd), rhodium (Rh), and gold (Au), or an alloy made of one of the metals as a major element and other metals as minor elements.

9. The probe substrate of claim 1, further comprising:
an insulation layer formed on the surface of the support substrate other than at the surface of a bending space of the support substrate.

10. The probe substrate of claim 9, wherein
the insulation layer is formed at a space between the support substrate and the beam, and the connection member contacts the beam.

11. A method for manufacturing a probe substrate comprising:
forming a plurality of through holes in a support substrate;
forming an insulation layer on a surface of the support substrate;
forming a connection member in the respective through hole;
forming a plurality of beams on the insulation layer formed on the support substrate;
forming a contactor at one end of the beam by using the same metal as that of the beam; and
etching a predetermined part of the support substrate provided at a lower part of the beam to form a bending space,
wherein the forming of the contactor comprises
forming a contactor forming photoresist layer pattern for exposing one end of the beam on the beam, and
forming a metal layer on the exposed part of the beam by using an electroplating method.

12. The method of claim 11, further comprising,
before forming a plurality of through holes on the support substrate,
forming a plurality of microtrenches on the support substrate; and
filling the microtrenches with a thermal oxide layer to form a trench oxide layer.

13. The method of claim 11, wherein
the trench oxide layer is located adjacent to an edge between the bending space and the beam.

14. The method of claim 13, wherein
the forming of a plurality of beams includes:
patterning the insulation layer formed on the support substrate and exposing part of the support substrate corresponding to the bending space;
forming a sacrificial metal layer on the exposed support substrate;
forming a seed layer on the sacrificial metal layer and the insulation layer; forming a photoresist layer pattern for generating a beam on the seed layer, the photoresist layer pattern for generating a beam exposed part of the seed layer; and
filling the part exposed by the photoresist layer pattern for generating a beam with metal by using an electroplating method, thereby forming a plurality of beams.

15. The method of claim 14, wherein
The photoresist layer pattern for generating a beam includes a plurality of long bar patterns in a horizontal direction.

16. The method of claim 15, wherein
one end of the long bar pattern of the beam forming photoresist layer pattern corresponds to the connection member.

17. The method of claim 14, wherein
the beam is made of one of nickel (Ni), copper (Cu), platinum (Pt), palladium (Pd), rhodium (Rh), and gold (Au), or an alloy made of one of the metals as a major element and other metal elements.

18. The method of claim 11, wherein
the etching of part of the support substrate to form a bending space includes:
etching the sacrificial metal layer to form a space between the beam and the support substrate; and
etching the support substrate exposed through the space and forming the bending space.

19. The method of claim 11, wherein
the forming of the contactor includes:
forming a first photoresist layer pattern exposing one end of the beam on the beam;
forming a first tip on the exposed part of the beam using a first electroplating process;
forming a second photoresist layer pattern for exposing at least part of the first tip on the first tip; and
forming a second tip on the exposed part of the first tip using a second electroplating process.

20. The method of claim 19, wherein
the first photoresist layer pattern is circular-shaped or quadrilateral-shaped.

21. The method of claim 19, wherein
the forming of the second tip includes:
forming the second photoresist layer pattern on the first photoresist layer pattern and the first tip to expose a center of the first tip; and
filling the part exposed by the second photoresist layer pattern with the metal by using an electroplating method, thereby forming the second tip.

22. The method of claim 21, further comprising
forming a third tip having an edge on the second tip.

23. The method of claim 22, wherein
the forming of the third tip includes:
forming a third photoresist layer pattern on the second photoresist layer pattern and the second tip to expose a center of the second tip; and
filling the part exposed by the third photoresist layer pattern with metal by using an electroplating method to form the third tip.

24. The method of claim 23, further comprising
repeating the process for forming the first to third tips to form a tip having a diameter that is less than the third tip on the third tip.
